# EUROPEAN PATENT APPLICATION

(11) **EP 4 654 242 A1**
(43) Date of publication of application: **26.11.2025**
(21) Application number: 24177079.1
(22) Date of filing: 21.05.2024
(51) Int. Cl.: H01H 85/24, G01R 31/74, H01H 85/30, H01H 85/34

(54) **FUSE AND METHOD TO PREVENT MISUSE OF THE SAME**

(71) Applicant: VOLVO TRUCK CORPORATION, 405 08 Göteborg (SE)
(72) Inventor: LEROY, Frederic, 69008 LYON (FR); DE BRITO, David, 38230 Charvieu (FR)
(74) Representative: Germain Maureau

(57) **Abstract**

A fuse (F1, F2, F3, ..., FN), comprising at least one of :
- an identification component (IC), the identification component (IC) communicating to a receiver (R) an identification information concerning the fuse (F1, F2, F3, ..., FN);
- an electrical sensor (ES), the electrical sensor (ES) communicating to the receiver (R) a measure of an intensity or of a voltage of a current flowing in the fuse (F1, F2, F3, ..., FN);
- a temperature sensor (TS), the temperature sensor (TS) communicating to the receiver a temperature of the fuse.

## Description

### TECHNICAL FIELD

The disclosure relates generally to fuse. In particular aspects, the disclosure relates to a method to prevent misuse of fuse as protection component. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

It is known to use fuses as protection electrical component, generally included inside a fuse and relay center or inside a fuse box, or inside an electronic control unit (ECU).

But fuses may be misused when the fuse is replaced by a wrong fuse size or type, or when an external component, such as a copper bridge wire or an aluminum paper which is not a fuse, is connected to the terminals of the fuse. Such misuse of fuse may cause thermal event and failure of electrical equipment.

It is the aim of this disclosure to provide a method to prevent such misuse of fuse.

### SUMMARY

According to a first aspect of the disclosure, the disclosure relates to a fuse comprising at least one of :
- an identification component, the identification component communicating to a receiver an identification information concerning the fuse;
- an electrical sensor, the electrical sensor comprising a current sensor and a voltage sensor, the electrical sensor communicating to the receiver a measure of an intensity and/or of a voltage of a current flowing in the fuse;
- a temperature sensor, the temperature sensor communicating to the receiver a temperature of the fuse. The first aspect of the disclosure may seek to prevent misuse of the fuse. A technical benefit may include providing information on the fuse which may help detecting misuse of the fuse.

Optionally in some examples, including in at least one preferred example, the identification component is a RFID chip.

According to a second aspect of the disclosure, the disclosure relates to an assembly comprising a fuse box and a fuse according to embodiments described herein above, the fuse box comprising a receptacle for the fuse and a receiver and a processing unit, the receiver being configured to receive information from at least one of:
- the identification component;
- the electrical sensor, the electrical sensor comprising a current sensor and a voltage sensor;
- the temperature sensor;
and the processing unit being configured to process the information communicated by the receiver to the processing unit, to determine whether the fuse is undersized or oversized or is not a standard fuse. The second aspect of the disclosure may seek to detect a misuse of the fuse in the fuse box. A technical benefit may include detecting whether the fuse is undersized or oversized or is not a standard fuse.

Optionally in some examples, including in at least one preferred example, the assembly further comprises a detector detecting the replacement of the fuse, and a counter counting a number of times that the fuse is replaced during a period of time, the counter being configured to communicate the number of times to the processing unit, the processing unit being configured to determine whether the number of times is greater than a threshold. A technical benefit may include detecting that the fuse is not adapted to its use.

Optionally in some examples, including in at least one preferred example, the detector is a camera viewing the fuse during a time slot when the fuse box is opened to replace the fuse. A technical benefit may include detecting that the fuse is being replaced.

According to a third aspect of the disclosure, the disclosure relates to a vehicle comprising the fuse, or comprising the assembly, according to any of the embodiments described herein above.

According to a fourth aspect of the disclosure, the disclosure relates to a method for determining whether a fuse in a fuse box is undersized or oversized or is not a standard fuse, the fuse box comprising a receptacle for the fuse and a receiver and a processing unit, the fuse comprising at least one of :
- an identification component, the identification component communicating to the receiver an identification information concerning the fuse;
- an electrical sensor, the electrical sensor comprising a current sensor and a voltage sensor, the electrical sensor communicating to the receiver a measured intensity or a measured voltage of a current flowing in the fuse;
- a temperature sensor, the temperature sensor communicating to the receiver a measured temperature of the fuse;
the method comprising:
- receiving, by the receiver, at least one information among :
   - the identification information on the fuse, from the identification component;
   - the measured intensity and/or the measured voltage of the current flowing in the fuse, from the electrical sensor;
   - the measured temperature of the fuse, from the temperature sensor,
- communicating, by the receiver to the processing unit, the at least one information,
- processing, by the processing unit, the at least one information received by the receiver to determine whether the fuse is undersized or oversized or is not a standard fuse. The fourth aspect of the disclosure may seek to detect a misuse of the fuse in the fuse box. A technical benefit may include detecting whether the fuse is undersized or oversized or is not a standard fuse.

Optionally in some examples, including in at least one preferred example, the processing unit determines that the fuse is undersized, or oversized or not a standard fuse based on the identification information. A technical benefit may include detecting that the fuse is misused.

Optionally in some examples, including in at least one preferred example, the processing unit determines that the fuse is oversized, based on the measured intensity of the current flowing through the fuse. A technical benefit may include detecting that the fuse is misused.

Optionally in some examples, including in at least one preferred example, the processing unit determines that the fuse is not a standard fuse, based on the measured intensity of the current flowing through the fuse. A technical benefit may include detecting that the fuse is misused.

Optionally in some examples, including in at least one preferred example, the processing unit determines that the fuse is not a standard fuse, based on a resistance of the fuse computed from the measured intensity and the measured voltage of the current flowing through the fuse. A technical benefit may include detecting that the fuse is misused.

Optionally in some examples, including in at least one preferred example, the processing unit determines that the fuse is not a standard fuse, based on the measured temperature of the fuse. A technical benefit may include detecting that the fuse is misused.

Optionally in some examples, including in at least one preferred example, the method further comprises:
- detecting, by a detector, a replacement of the fuse,
- counting, by a counter, a number of times that the fuse is replaced during a period of time,
- determining, by the processing unit, whether the number of times is greater than a threshold. A technical benefit may include detecting that the fuse is misused.

Optionally in some examples, including in at least one preferred example, the detector is a camera configured to view the fuse during a time slot during which the fuse box is opened to replace the fuse. A technical benefit may include detecting that the fuse is misused.

Optionally in some examples, including in at least one preferred example, the processing unit determines that the fuse is undersized, based on the number of times that the fuse is replaced during the period of time. A technical benefit may include detecting that the fuse is misused.

Optionally in some examples, including in at least one preferred example, the method further comprises at least one of:
- cutting an electrical power supplied to the fuse,
- logging the information determined by the processing unit to a diagnostic trouble code
- displaying a warning information on a display unit, the warning information comprising a criticity level
- producing a warning sound
- sending the information determined by the processing unit to a fleet management system. A technical benefit may include planning a replacement of the misused fuse, based on the criticity level of the warning information.

Optionally in some examples, including in at least one preferred example, the display unit is in a cabin of a vehicle comprising the fuse box. A technical benefit may include that the driver is warned immediately on the misuse of a fuse of the vehicle.

Optionally in some examples, including in at least one preferred example, the sound is produced in the cabin of the vehicle comprising the fuse box. A technical benefit may include that the driver is warned immediately on the misuse of a fuse of the vehicle.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
FIG. 1 is an exemplary assembly comprising a set of fuses according to an example.
FIG. 2 is another exemplary fuse box comprising a fuse according to another example.
FIG. 3 is an exemplary diagram of the method according to an example.

### DETAILED DESCRIPTION

The detailed description set forth below provides information and examples of the disclosed technology with sufficient detail to enable those skilled in the art to practice the disclosure.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

The disclosure aims at preventing using undersized or oversized fuse, to prevent possible thermal events and possible electrical failure of an electrical component which may result from such misuse.

During the product life cycle, the fuses are handled by the customer, which can lead to some mistakes. Three types of mistakes and different consequences may be identified, such as :
- a user replaces a fuse with an undersized fuse, in which case, the fuse will break again and again;
- a user replaces a fuse with an oversized fuse, in which case, the fuse will not break, but may lead to a thermal event;
- a user replaces fuse with something which is not a fuse, such as copper wire or aluminum paper, which may also lead to a thermal event.

The disclosure aims at preventing these different kinds of misuse, by warning the user before any thermal event occurs.

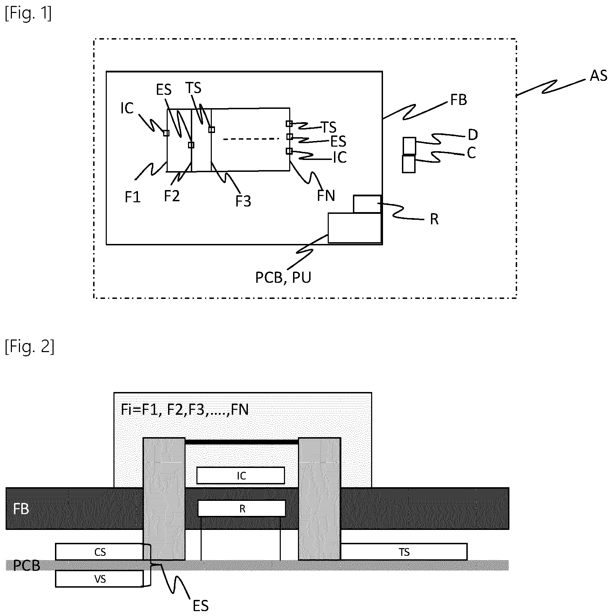

To that end, figure 1 and 2 presents, an example of a fuse box FB, including a set of fuses Fi=F1, F2, F3, ..., FN, each fuse Fi of the set comprising at least one of :
- an identification component IC, the identification component IC communicating to a receiver R an identification information concerning the fuse F1, F2, F3, ..., FN; the identification component may for example be an RFID chip attached to the fuse, wirelessly communicating the identification information to a receiver R, which may be embedded inside the fuse box FB; according to another example, the identification component may be a magnet molded inside a plastic fuse housing and detected by the fuse box housing.
- an electrical sensor ES, the electrical sensor ES comprising a current sensor CS and a voltage sensor VS, the electrical sensor ES communicating, for example wirelessly to the receiver R, a measure of an intensity and/or of a voltage of a current flowing in the fuse F1, F2, F3, ..., FN; the electrical sensor ES, comprises a current sensor CS and a voltage sensor VS, attached to each fuse F1, F2, F3, ..., FN and configured to measure respectively the intensity and the voltage of a current flowing in said fuse F1, F2, F3, ..., FN. For example, one or more current sensors configured to measure the current flowing through each fuse, or one or more voltage sensors configured to measure the voltage of each fuse, may be soldered on a printed circuit board PCB. Then, thanks to the current and voltage measures, a PU located on the printed circuit board PCB, is able to calculate in real time each fuse resistance.
- a temperature sensor TS, the temperature sensor TS communicating, for example wirelessly to the receiver R, a temperature of the fuse F1, F2, F3, ..., FN; the temperature sensor TS attached to each fuse F1, F2, F3, ..., FN may be any temperature sensor configured to measure the temperature said fuse F1, F2, F3, ..., FN. For example, the temperature sensor TS is a PTC or thermocouple sensor, optionally inside the fuse box, which is not necessarily communicating wirelessly.

This sensor will monitor the fuse surrounding temperature and if sudden change appears or in comparison with the PCB temperature will be able to determine if some abnormal overheating is occurring.

The value of the temperature may also considered while calculating the fuse resistance

In the example represented in figure 1, a set of N fuses Fi=F1, F2, F3, ..., FN is included in the fuse box, N being any number equal to or greater than 1. Each fuse Fi=F1, F2, F3, ..., FN has a specific receptacle in the fuse box FB.

As illustrated in figure 1, an aspect of the disclosure relates to an assembly AS comprising the fuse box FB, the fuse box FB comprising not only the fuses F1, F2, F3, ..., FN, but also further comprising the receiver R and a processing unit PU, the processing unit PU being configured to process the information communicated by the receiver R to the processing unit PU, to determine whether the fuse F1, F2, F3, ..., FN is undersized or oversized or is not a standard fuse.

The assembly AS may for example belong to a vehicle, for example a truck.

For example, the processing unit PU may determine that the fuse F1, F2, F3, ..., FN is undersized based on the identification information, which may comprise for example a fuse type or a fuse size, transmitted by the identification component IC to the receiver R and then to the processing unit PU which may compare the identification information with a database comprising information concerning the required type or size of this fuse. If the identification information does not match with the required type or size of this fuse, the processing unit PU will trigger at least one of many possible warning actions, such as :
- cutting 107 an electrical power supplied to the fuse F1, F2, F3, ..., FN,
- logging 108 the information determined by the processing unit PU to a diagnostic trouble code (DTC),
- displaying 109 a warning information on a display unit, for example in a cabin of a vehicle comprising the assembly AS, to warn the driver of said vehicle.
- producing 110 a warning sound, for example in the cabin of the vehicle.
- sending 111 the information determined by the processing unit to a fleet management system, managing a fleet of vehicles to which belongs the vehicle comprising the assembly AS.

For example, the processing unit PU may determine that the fuse F1, F2, F3, ..., FN is undersized based on a number of time that a fuse F1, F2, F3, ..., FN has been replaced during a certain period of time, in particular when this number of time is greater than a predetermined threshold. To that end, the assembly AS may further comprise a detector D detecting the replacement of the fuse F1, F2, F3, ..., FN, and a counter C counting a number of times that the fuse is replaced during a period of time, the counter C being configured to communicate the number of times to the processing unit PU. For example, the detector may be a camera viewing the fuse F1, F2, F3, ..., FN during a time slot when the fuse box FB is opened to replace the fuse F1, F2, F3, ..., FN. According to another example of realization, the detection may result from an algorithm processing information from the detector, for example images from the camera.

For example, the processing unit PU may determine that the fuse F1, F2, F3, ..., FN is oversized either based on the identification information obtained from the identification component, or based on the measured intensity of the current flowing across said fuse F1, F2, F3, ..., FN when the measured intensity is greater than the intensity allowed by a usual size of the considered fuse F1, F2, F3, ..., FN. If the processing unit PU determines that the fuse F1, F2, F3, ..., FN is oversized, the processing unit PU may then trigger at least one of the many possible warning actions such as indicated previously.

For example, the processing unit PU may determine that the fuse F1, F2, F3, ..., FN is not a standard fuse either based on the identification information which will be missing in that case because no identification component will be attached to said non-standard fuse, or based on the measured intensity of the current flowing across said fuse F1, F2, F3, ..., FN when the measured intensity is greater than the intensity allowed by a usual size of the considered fuse F1, F2, F3, ..., FN, or based on a resistance of the considered fuse calculated by the processing unit PU from the measured intensity and voltage of the current flowing through said fuse, when said resistance is not in line with the normal fuse resistance, or based on the measured temperature of said fuse, when said measured temperature indicates that the fuse starts to heat due to over current flowing through said fuse. If the processing unit PU determines that the fuse F1, F2, F3, ..., FN is not a standard fuse, the processing unit PU may then trigger at least one of the many possible warning actions such as indicated previously.

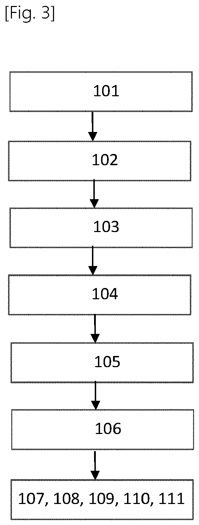

According to a further aspect, the disclosure relates to a method 100 for determining whether a fuse F1, F2, F3, ..., FN in a fuse box FB is undersized or oversized or is not a standard fuse, which will be described in reference to figure 3.

The method 100 comprises:
- receiving 101, by the receiver R, at least one information among :
- the identification information on the fuse F1, F2, F3, ..., FN, from the identification component IC;
- the measured intensity and/or the measured voltage of the current flowing in the fuse F1, F2, F3, ..., FN, from the electrical sensor ES;
- the measured temperature of the fuse F1, F2, F3, ..., FN, from the temperature sensor TS,
- communicating 102, by the receiver R to the processing unit PU, the at least one information,
- processing 103, by the processing unit PU, the at least one information received by the receiver R to determine whether the fuse is undersized or oversized or is not a standard fuse.

Optionally the method 100 further comprises :
- detecting 104, by a detector D, a replacement of the fuse, the detector being for example a camera configured to view the fuse F1, F2, F3, ..., FN during a time slot during which the fuse box FB is opened to replace the fuse F1, F2, F3, ..., FN,
- counting 105, by a counter C, a number of times that the fuse F1, F2, F3, ..., FN is replaced during a period of time,
- determining 106, by the processing unit PU, whether the number of times is greater than a threshold.

## Claims

1. A fuse (F1, F2, F3, ..., FN), comprising at least one of:
- an identification component (IC), the identification component (IC) communicating to a receiver (R) an identification information concerning the fuse (F1, F2, F3, ..., FN);
- an electrical sensor (ES), the electrical sensor (ES) comprising a current sensor and a voltage sensor, the electrical sensor (ES) communicating to the receiver (R) a measure of an intensity and/or of a voltage of a current flowing in the fuse (F1, F2, F3, ..., FN);
- a temperature sensor (TS), the temperature sensor (TS) communicating to the receiver a temperature of the fuse.

2. A fuse according to claim 1, wherein the identification component (IC) is a RFID chip.

3. An assembly (AS) comprising a fuse box (FB) and a fuse (F1, F2, F3, ..., FN) according to claim 1 or 2, the fuse box (FB) comprising a receptacle for the fuse and a receiver (R) and a processing unit (PU), the receiver (R) being configured to receive information from at least one of:
- the identification component (IC);
- the electrical sensor (ES), the electrical sensor (ES) comprising a current sensor and a voltage sensor;
- the temperature sensor (TS);
and the processing unit (PU) being configured to process the information communicated by the receiver (R) to the processing unit (PU), to determine whether the fuse (F1, F2, F3, ..., FN) is undersized or oversized or is not a standard fuse.

4. An assembly (AS) according to claim 3, the assembly further comprising a detector (D) detecting the replacement of the fuse (F1, F2, F3, ..., FN), and a counter (C) counting a number of times that the fuse is replaced during a period of time, the counter (C) being configured to communicate the number of times to the processing unit (PU), the processing unit (PU) being configured to determine whether the number of times is greater than a threshold.

5. An assembly (AS) according to claim 4, wherein the detector is a camera viewing the fuse (F1, F2, F3, ..., FN) during a time slot when the fuse box (FB) is opened to replace the fuse (F1, F2, F3, ..., FN).

6. A vehicle comprising the fuse (F1, F2, F3, ..., FN) according to claim 1 or 2, or comprising the assembly (AS) according to any of claims 3 to 5.

7. A method (100) for determining whether a fuse (F1, F2, F3, ..., FN) in a fuse box (FB) is undersized or oversized or is not a standard fuse, the fuse box (FB) comprising a receptacle for the fuse and a receiver (R) and a processing unit (PU), the fuse (F1, F2, F3, ..., FN) comprising at least one of :
- an identification component (IC), the identification component (IC) communicating to the receiver an identification information concerning the fuse (F1, F2, F3, ..., FN);
- an electrical sensor (ES), the electrical sensor (ES) comprising a current sensor and a voltage sensor, the electrical sensor (ES) communicating to the receiver a measured intensity or a measured voltage of a current flowing in the fuse (F1, F2, F3, ..., FN);
- a temperature sensor (TS), the temperature sensor (TS) communicating to the receiver a measured temperature of the fuse (F1, F2, F3, ..., FN);
the method comprising:
- receiving (101), by the receiver (R), at least one information among :
- the identification information on the fuse (F1, F2, F3, ..., FN), from the identification component (IC);
- the measured intensity and/or the measured voltage of the current flowing in the fuse (F1, F2, F3, ..., FN), from the electrical sensor (ES);
- the measured temperature of the fuse (F1, F2, F3, ..., FN), from the temperature sensor (TS),
- communicating (102), by the receiver (R) to the processing unit (PU), the at least one information,
- processing (103), by the processing unit (PU), the at least one information received by the receiver (R) to determine whether the fuse is undersized or oversized or is not a standard fuse.

8. The method of claim 7, wherein the processing unit determines that the fuse is undersized, or oversized or not a standard fuse based on the identification information.

9. The method of anyone of claims 7 to 8, wherein the processing unit determines that the fuse is oversized, based on the measured intensity of the current flowing through the fuse.

10. The method of anyone of claims 7 to 9, wherein the processing unit determines that the fuse is not a standard fuse, based on the measured intensity of the current flowing through the fuse.

11. The method of anyone of claims 7 to 10, wherein the processing unit determines that the fuse is not a standard fuse, based on a resistance of the fuse computed from the measured intensity and the measured voltage of the current flowing through the fuse.

12. The method of anyone of claims 7 to 11, wherein the processing unit determines that the fuse is not a standard fuse, based on the measured temperature of the fuse.

13. The method of anyone of claims 7 to 12, further comprising:
- detecting (104), by a detector (D), a replacement of the fuse,
- counting (105), by a counter (C), a number of times that the fuse (F1, F2, F3, ..., FN) is replaced during a period of time,
- determining (106), by the processing unit (PU), whether the number of times is greater than a threshold.

14. The method of claim 13, wherein the detector (D) is a camera configured to view the fuse (F1, F2, F3, ..., FN) during a time slot during which the fuse box (FB) is opened to replace the fuse (F1, F2, F3, ..., FN).

15. The method of anyone of claims 13 or 14, wherein the processing unit determines that the fuse is undersized, based on the number of times that the fuse (F1, F2, F3, ..., FN) is replaced during the period of time.
